# FASCICULE DE BREVET EUROPEEN

(11) **EP 2 936 954 B1**
(45) Date de publication et mention de la délivrance du brevet: **16.02.2022**
(21) Numéro de dépôt: 13805361.6
(22) Date de dépôt: 13.12.2013
(51) Int. Cl.: H05K 7/20, B60H 1/00

(54) **DISPOSITIF DE VENTILATION POUR INSTALLATION DE VENTILATION, CHAUFFAGE ET/OU CLIMATISATION**
BELÜFTUNGSVORRICHTUNG FÜR EINE LÜFTUNGS-, HEIZUNGS- UND/ODER KLIMAANLAGE
VENTILATION DEVICE FOR A VENTILATION, HEATING AND/OR AIR-CONDITIONING UNIT

(30) Priorité: 19.12.2012 FR 1262304
(43) Date de publication de la demande: 28.10.2015
(73) Titulaire: Valeo Systèmes Thermiques, 78320 Le Mesnil-Saint-Denis (FR)
(72) Inventeur: CHAUVIN, Karen, F-78230 Le Pecq (FR); GOUMAIN, Xavier, F-78180 Montigny Le Bretonneux (FR); KIEL, Friedbald, F-77300 Fontainebleau (FR)
(74) Mandataire: Valeo Systèmes Thermiques
(86) Numéro de dépôt international: PCT/EP2013/076513
(87) Numéro de publication internationale: WO 2014/095616

(56) Documents cités:
- WO-A2-03/037664
- US-A- 6 043 986
- US-A1- 2006 028 796
- US-A1- 2011 110 059

## Description

Le secteur technique de la présente invention est celui des dispositifs de ventilation destinés à mettre en mouvement un flux d'air à l'intérieur d'une installation de ventilation, chauffage et/ou climatisation pour véhicule automobile.

Une telle installation de ventilation, chauffage et/ou climatisation est classiquement formée par un boîtier délimitant un canal à l'intérieur duquel un flux d'air se déplace. Des échangeurs de chaleur sont logés à l'intérieur de ce boîtier en vue de chauffer ou de refroidir le flux d'air envoyé dans l'habitacle du véhicule automobile. Le flux d'air est mis en circulation dans le boîtier par un dispositif de ventilation, placé sous la dépendance d'un moyen de commande, et constitué d'un support logeant un moteur électrique qui entraîne en rotation une hélice. Le support est rapporté sur le boîtier et la mise en rotation de l'hélice permet de prélever le flux d'air à l'extérieur du boîtier pour l'envoyer à l'intérieur du boîtier. C'est ainsi qu'un échange thermique est réalisé entre le flux d'air et le ou les échangeurs de chaleur, de manière à conditionner thermiquement l'habitacle du véhicule.

Dans le domaine des dispositifs de ventilation, il est connu d'installer le moyen de commande immédiatement au voisinage du moteur électrique qui entraîne l'hélice. Un tel moyen de commande est ainsi solidarisé sur le support. Le dispositif de commande gère la vitesse de rotation de l'hélice en agissant sur la tension du moteur. Ce type de gestion fait appel à des composants électroniques qui sont rassemblés sur une carte de circuit imprimé constitutive du moyen de commande.

Certains de ces composants électroniques dégagent de la chaleur. Il est alors connu d'adjoindre à la carte de circuit imprimé un radiateur dont la fonction est de dissiper les calories émises par les composants électroniques. Ce radiateur est plaqué sur une face de la carte de circuit imprimé, une pâte conductrice thermique étant interposée entre le radiateur et la face de la carte de circuit imprimé de manière à garantir une bonne conduction thermique entre ladite carte et le radiateur.

La structure évoquée ci-dessus présente plusieurs inconvénients. En premier lieu, un tel radiateur est une pièce massive qui occupe une place importante dans le dispositif de ventilation, ce qui forme une contrainte qui limite les possibilités de réduction de l'encombrement de ce dispositif de ventilation. Par ailleurs, le poids du dispositif de ventilation connu est également grevé par la présence de ce radiateur, celui-ci étant fabriqué en un alliage d'aluminium. Enfin, le radiateur est une pièce qui représente un coût non négligeable dans la fonction de ventilation.

Le document US 2006/028796 décrit un dispositif de ventilation comprenant une hélice génératrice d'un flux d'air et apte à être entraînée par un moteur électrique, et une carte de circuit imprimé sur laquelle est solidarisé au moins un composant électronique susceptible de dégager des calories, ladite carte de circuit imprimé comprenant au moins un trou traversant ménagé dans une partie de ladite carte de circuit imprimé, le dispositif de ventilation étant configuré de sorte que ladite partie de carte de circuit imprimé est apte à être léchée par le flux d'air généré par l'hélice. Le refroidissement de la carte de circuit imprimé de D4 repose entièrement sur la capacité de ladite carte à être ventilée à travers des trous.

Le but de la présente invention est donc de résoudre les inconvénients décrits ci-dessus principalement en organisant le dispositif de ventilation de telle manière que le radiateur massif de l'art antérieur puisse être de taille réduite, voire supprimé totalement. Ainsi, un flux d'air mis en circulation par l'hélice est envoyé sur une face de la carte de circuit, particulièrement sur une zone dans laquelle est réalisé au moins un trou, un tel trou étant par exemple métallisé sur sa périphérie, ou encore comblé, de manière à former un drain thermique.

L'invention a donc pour objet un dispositif de ventilation d'une installation de ventilation d'un habitacle de véhicule automobile comprenant une hélice génératrice d'un flux d'air et apte à être entraînée par un moteur électrique, et une carte de circuit imprimé sur laquelle est solidarisé au moins un composant électronique susceptible de dégager des calories, ladite carte de circuit imprimé comprenant au moins un trou traversant ménagé dans une partie de ladite carte de circuit imprimé, le dispositif de ventilation étant configuré de sorte que ladite partie de carte de circuit imprimé comprenant au moins un trou traversant est apte à être léchée par le flux d'air généré par l'hélice. Une telle structure permet de dissiper les calories directement entre la carte de circuit imprimé et le flux d'air forcé, ce qui permet d'éviter le recours à un radiateur. Ainsi, le dispositif de ventilation selon l'invention ne comprend pas de radiateur.

La carte de circuit imprimé forme un dispositif de commande apte à piloter le moteur électrique. Ce dispositif de commande est le moyen qui détermine la vitesse de rotation de l'hélice, en fonction de demandes émises par le véhicule automobile.

De manière plus précise, la carte de circuit imprimé est délimitée par une première face sur laquelle est solidarisé au moins le composant électronique susceptible de dégager des calories et par une deuxième face opposée à la première face par rapport à ladite carte de circuit imprimé, ladite deuxième face formant au moins ladite partie de carte de circuit imprimé léchée par le flux d'air. On comprend ainsi que le flux d'air vient au contact de cette deuxième face de manière à capter les calories présentes sur la carte de circuit imprimé.

Un moyen conducteur de calories s'étend dans le trou. Ce moyen conducteur de calories forme un drain thermique entre les calories présentes sur la première face et générées par le composant électronique, et le flux d'air qui lèche la deuxième face.

Selon un exemple de réalisation, le moyen conducteur de calories est formé par une métallisation du trou. La paroi de la carte de circuit imprimé délimitant le trou est ainsi couverte par une couche de métal qui forme un via thermique.

Selon une variante, une extrémité du moyen conducteur de calories débouche de la deuxième face de manière à être léchée par le flux d'air. On comprend ici que le moyen conducteur de calories s'étend à partir de la première face jusqu'à la deuxième face de manière à s'étendre au cœur du flux d'air.

Avantageusement encore, le moyen conducteur de calories est en contact avec une piste électriquement conductrice qui s'étend sur la première face au moins jusqu'au composant électronique. La piste conductrice, en plus de conduire le courant électrique, est agencée pour drainer les calories générées par le composant électronique vers le moyen conducteur de calories.

De manière plus précise, un périmètre externe du composant électronique délimite une première emprise sur la première face, le trou délimite une deuxième emprise sur la première face, la première emprise et la deuxième emprise étant séparées par une distance non-nulle. En d'autres termes, le composant électronique n'est pas disposé au dessus du trou, le drain thermique entre ce composant électronique et le trou étant alors opéré par une piste électriquement conductrice qui chemine au moins entre ces deux éléments.

Alternativement, un périmètre externe du composant électronique délimite une première emprise sur la première face, le trou délimite une deuxième emprise sur la première face, la première emprise et la deuxième emprise se superposant au moins partiellement.

Les emprises évoquées dans les deux situations ci-dessus correspondent à une surface sur la carte de circuit imprimé mesurée dans le prolongement de l'élément considéré. Une emprise forme donc une projection du composant électronique, du trou ou de la pluralité de trous, perpendiculaire au plan de la carte de circuit imprimé.

Le dispositif de ventilation selon l'invention comprend, notamment, un dissipateur thermique solidarisé sur la carte de circuit imprimé au droit du trou, ledit dissipateur débouchant de la deuxième face de manière à être léché par le flux d'air.

Un tel dissipateur thermique est solidarisé sur la deuxième face, avantageusement par brasage.

De manière alternative ou complémentaire, le dissipateur thermique est solidarisé sur la première face, également par exemple par brasage.

Le dissipateur thermique comprend une tête formant butée contre la carte de circuit imprimé.

De manière avantageuse, la partie de la carte de circuit imprimé léchée par le flux d'air porte au moins une pluralité de pistes conductrices agencées pour limiter un risque de contact électrique entre deux pistes conductrices qui cheminent sur ladite partie. Un tel agencement est avantageux car le flux d'air qui lèche la carte de circuit imprimé peut comporter des corps étrangers (impuretés, particules, eau) potentiellement à l'origine de court-circuit. On évite ainsi un phénomène de migration électrochimique liée à la présence d'eau, de corps étrangers et d'une tension entre ces pistes. Ces dernières sont alors disposées sur la deuxième face au niveau de la partie de la carte de circuit imprimé, de manière à limiter le risque de contact électrique entre pistes, en raison de ce phénomène. Selon un exemple de réalisation, un tel agencement résulte d'une distance supérieure à 1.5 mm entre deux pistes immédiatement adjacentes.

Selon une caractéristique de l'invention, il est prévu une paroi séparant la carte de circuit imprimé en ladite partie léchée par le flux d'air et une zone dépourvue dudit flux d'air forcé. Une telle paroi peut, par exemple, faire partie d'un support constitutif du dispositif de ventilation. Un bord de cette paroi vient alors s'appliquer contre la deuxième face de la carte de circuit imprimé, de manière à canaliser le flux d'air.

La partie de la carte de circuit imprimé léchée par le flux d'air est préférentiellement dépourvue de composant électronique. Comme exposé plus haut, cette partie peut comprendre des pistes conductrices qui cheminent sur la deuxième face.

Selon une caractéristique de l'invention, au moins un composant électronique est solidarisé sur ladite zone, notamment sur la deuxième face.

L'invention couvre enfin une installation de ventilation comprenant un dispositif de ventilation selon l'une quelconque des caractéristiques détaillées ci-dessus.

Un tout premier avantage selon l'invention réside dans la possibilité de concevoir un dispositif de ventilation plus léger, plus compact et moins coûteux que ceux de l'art antérieur, tout en garantissant une fiabilité compatible avec l'utilisation dans le secteur automobile en assurant une fonction de refroidissement des composants qui dissipent de la chaleur.

D'autres caractéristiques, détails et avantages de l'invention ressortiront plus clairement à la lecture de la description donnée ci-après à titre indicatif en relation avec des dessins dans lesquels :
- la figure 1 est une vue schématique du dispositif de ventilation selon l'invention,
- la figure 2 est une vue en coupe illustrant des détails d'une première variante de réalisation du dispositif de ventilation selon l'invention,
- la figure 3 est une vue en coupe illustrant des détails d'une deuxième variante de réalisation du dispositif de ventilation selon l'invention,
- la figure 4 est une vue en coupe illustrant des détails d'une troisième variante de réalisation du dispositif de ventilation selon l'invention,
- la figure 5 est une vue en coupe illustrant des détails d'une quatrième variante de réalisation du dispositif de ventilation selon l'invention, et
- la figure 6 est une vue en coupe illustrant des détails d'une huitième variante de réalisation du dispositif de ventilation selon l'invention.

Il faut noter que les figures exposent l'invention de manière détaillée pour mettre en œuvre l'invention, lesdites figures pouvant bien entendu servir à mieux définir l'invention, le cas échéant.

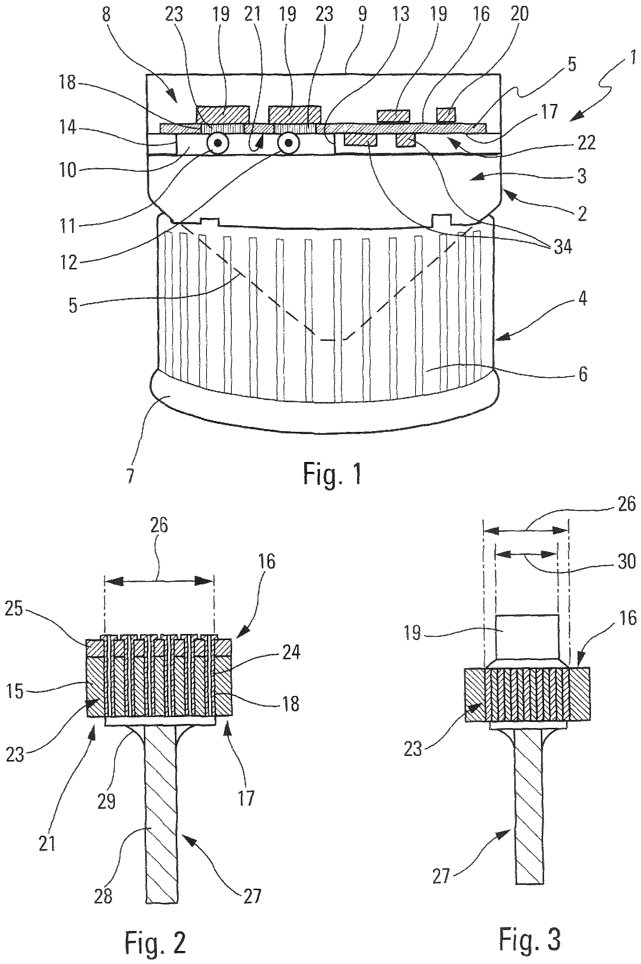

La figure 1 illustre un dispositif de ventilation 1 selon l'invention. Un tel dispositif de ventilation comprend un support 2 à l'intérieur duquel est logé un moteur électrique 3. Selon un exemple de réalisation, un tel moteur est du type à balais et collecteur, mais l'invention vise préférentiellement un moteur de type sans balai.

Le moteur électrique 3 entraîne en rotation une hélice 4 constituée d'un bol 5 représenté en pointillé sur cette figure. Ce bol forme un moyen d'entraînement de l'hélice puisque un arbre du moteur est relié à ce bol 5. Un tel bol est par exemple plein, en ce sens que sa paroi est dépourvue d'ouverture. Selon une autre alternative, un tel bol 5 présente une pluralité d'ouvertures.

A la périphérie d'un tel bol s'étend une pluralité de pales 6 selon une direction parallèle à une direction d'extension de l'arbre du moteur. L'extrémité de chaque pale est jointe par un bandeau 7. Une telle hélice 4 forme ainsi une hélice en cage d'écureuil, autrement appelé turbine radiale.

A l'opposé de l'hélice 4 par rapport au moteur électrique 3, on trouve un dispositif de commande 8 dont la fonction est de piloter la vitesse de rotation de l'hélice 4 en contrôlant la tension ou le courant envoyé au moteur électrique 3. Un tel dispositif de commande 8 est installé contre le support 3 de manière à pouvoir être exposé au flux d'air généré par l'hélice 4, un tel dispositif de commande étant recouvert par un capot 9 de manière limiter l'entrée de corps étranger dans la portion du dispositif de ventilation où est installé le dispositif de commande.

Le support 2 comprend un évidement 10 dans lequel le flux d'air mis en circulation par l'hélice 4 peut circuler, un tel flux d'air étant représenté de manière schématique par deux symboles référencés 11 et 12. Un tel évidement 10 est bordé latéralement par au moins une première paroi 13, et avantageusement par une seconde paroi 14. On comprend ainsi que le flux d'air 11, 12 est canalisé par le support 3 et au moins l'une ou l'autre des deux parois latérales référencées 13 et 14.

Ce canal est également délimité par le dispositif de commande 8. De manière plus précise, ce canal est délimité par une carte de circuit imprimé 15 constitutive du dispositif de commande 8. Cette carte de circuit imprimé 15 est formée par un substrat électriquement isolant, sur lequel est formé des pistes électriquement conductrices.

Cette carte de circuit imprimé 15 comprend une première face 16 et une deuxième face 17 opposée à la première face par rapport au corps de la carte de circuit imprimé. La portion de la carte de circuit imprimé 15 qui ferme le canal de circulation du flux d'air 11, 12, en combinaison avec la première paroi 13 et la deuxième paroi 14, forme une partie de ladite carte dans laquelle est ménagé au moins un trou 18, un tel trou étant traversant, c'est-à-dire débouchant dans la première face 16 et dans la deuxième face 17.

La première face 16 de la carte de circuit imprimé 15 est porteuse de composants électroniques, en particulier de composants de puissance 19 qui dissipent des calories et dont il est nécessaire d'assurer le refroidissement pour leur garantir un niveau de fiabilité compatible avec une application dans le domaine automobile. Ces composants qui dégagent des calories sont, par exemple, des transistors, notamment de type MOSFET, mais il peut également s'agir de condensateur ou de shunt. La première face 16 peut bien entendu recevoir d'autres composants électroniques 20 qui participent à la mise en œuvre du pilotage ou à la protection du moteur électrique.

La deuxième face 17 de la carte de circuit imprimé est partagée d'une part, en une partie 21 de carte de circuit imprimé 15 léchée par le flux d'air 11, 12 mis en circulation par l'hélice 4, et d'autre part, en une zone 22 non exposée au flux d'air généré par l'hélice 4. Le ou les trous 18 sont ménagés dans la partie 21 et sont agencés pour recevoir un moyen conducteur de calories.

Le partage entre la partie 21 de la carte de circuit imprimé et la zone 22 de cette même carte est organisé par la première paroi 13, et avantageusement par la deuxième paroi 14. On comprend donc que la deuxième face 17 qui se trouve au droit de la partie de la carte de circuit imprimé qui comporte au moins un trou 18 est léchée par le flux d'air 11, 12, de manière à la refroidir et corrélativement, de manière à refroidir les composants électroniques 19 qui dégagent des calories.

Une telle partie 21 de la carte de circuit imprimé forme un support pour des pistes conductrices. En d'autres termes, une pluralité de pistes conductrices chemine sur la deuxième face léchée par le flux d'air et elles sont arrangées de manière à limiter le risque de court-circuit entre deux pistes conductrices. Un tel agencement est, par exemple, une distance minimum séparant les pistes conductrices qui cheminent au niveau de la partie léchée par le flux d'air. Selon un exemple de réalisation, une telle distance est par exemple de 1.5 mm minimum.

Selon l'invention, la zone 22 peut comprendre au moins un composant électronique 34 solidarisé sur la deuxième face 17 qui s'étend au niveau de la zone 22. Cette zone comprend encore une pluralité de pistes conductrices.

Selon un mode de réalisation, le ou les trous 18 comportent un moyen conducteur de calories 23. Selon le mode réalisation de la figure 1, ce moyen conducteur de calories est réalisé par des via thermiques, éventuellement remplis d'un matériau conducteur thermique. En d'autres termes, la paroi interne de la carte de circuit imprimé qui borde le trou est métallisée, de manière à former un drain thermique qui s'étend de la première face 16 à la deuxième face 17 de la carte de circuit imprimé. Selon une variante, la zone centrale du trou entourée par la partie métallisée 24 peut être libre, formant ainsi un espace. Selon une autre alternative, la zone centrale du trou peut être comblée par un matériau, par exemple le cuivre d'une des pistes conductrices ou le matériau utilisé pour le brasage ou par coating.

Une extrémité des trous métallisés s'étend dans le plan de la deuxième face et se trouve ainsi léchée par le flux d'air 11, 12. Alternativement, une partie métallisée 24 des trous 18 peut dépasser du plan de la deuxième face 17 de manière à s'étendre dans le flux d'air 11, 12. Dans les deux cas évoqués ci-dessus, la ou les parois métallisées forment un drain thermique qui conduit les calories générées par le composant électronique 19 vers le flux d'air, de manière à les dissiper dans celui-ci.

Selon une première variante de l'invention représentée à la figure 2, le moyen conducteur de calories 23 est un ensemble de via thermiques formés par les trous métallisés 18, préférentiellement remplis d'un matériau conducteur thermique. Dans l'exemple de la figure 2, il est prévu une pluralité de trous 18 tous pourvus d'une paroi métallisée.

La partie métallisée 24 du trou 18 est, par exemple, contenue dans l'épaisseur de la carte de circuit imprimé 15 et elle est raccordée du côté de la première face 16 à une piste conductrice 25 qui chemine sur la première face 16. Selon cette première variante, le composant électronique qui dégage des calories n'est pas installé directement au droit des trous 18. Au contraire, celui-ci est éloigné des trous et la piste électriquement conductrice 25, en plus de conduire l'électricité, draine les calories en provenance du composant électronique vers la ou les parties métallisées 24 des trous 18. On comprend ici qu'un périmètre externe du composant électronique délimite sur la première face 16 une première emprise (non visible sur cette figure), alors que le trou ou la pluralité de trous 18, qui contient le moyen conducteur de calories 23, délimite une deuxième emprise 26 sur la première face 16, la première emprise et la deuxième emprise 26 étant séparées par une distance non-nulle. La première emprise est une aire de la première face 16 délimitée par une projection du composant électronique, perpendiculairement au plan de la carte de circuit imprimé. La deuxième emprise 26 est une aire de la première face 16 occupée par le trou 18. Dans le cas d'une pluralité de trous 18, la deuxième emprise 26 est délimitée par une périphérie entourant la pluralité de trous 18.

A l'opposé de la piste électriquement conductrice 25, la partie métallisée 24 des trous 18 se termine dans le plan de la deuxième face 17, et un dissipateur thermique 27 est solidarisé sur la carte sous le moyen conducteur de calories 23, un tel dissipateur thermique débutant à partir de la deuxième face 17 et se terminant dans l'évidement 10 délimitant le canal dans lequel circule le flux d'air. Un tel dissipateur thermique 27 est formé par un barreau 28 solidarisé par une brasure 29 sur la deuxième face 17, au droit du moyen conducteur de calories 23, c'est-à-dire au moins au niveau de la deuxième emprise 26.

Pour simplifier les figures 3 à 5, la partie métallisée 24 et les trous 18 ont été représentés de manière symbolique. Il est néanmoins clair que le contenu technique du mode de réalisation décrit ci-dessus et illustré à la figure 2 peut être transposé à l'un quelconque des modes de réalisation illustrés aux figures 3 à 5, en particulier à l'égard de la structure du moyen conducteur de calories 23.

La figure 3 montre une deuxième variante de l'invention proche de celle représentée à la figure 2. On détaillera ci-dessous les différences et on se reportera à la description de la figure 2 pour les éléments identiques.

Une différence réside dans le positionnement du composant électronique 19 susceptible de dégager des calories. Alors que sur la figure 2, un tel composant est à distance du ou des trous, le composant électronique 19 est ici solidarisé, notamment par un brasage, sur la première face 16 au droit de la pluralité de trous 18, et avantageusement au droit du moyen conducteur de calories 23. Autrement dit, un périmètre externe du composant électronique 19 délimite la première emprise, référencée ici 30, sur la première face 16. Cette première emprise 30 superpose la deuxième emprise 26 délimitant la périphérie entourant la pluralité de trous 18. L'invention couvre le cas montré sur cette figure où la première emprise 30 est totalement superposée sur la deuxième emprise 26, mais elle couvre également le cas où la première emprise 30 se superpose seulement partiellement avec la deuxième emprise 26. En d'autres termes, l'invention couvre la situation où le composant électronique 19 est entièrement disposé au dessus de la pluralité de trous 18 mais elle couvre également le cas où le composant électronique 19 chevauche seulement partiellement la pluralité de trous 18. La variante de cette figure comporte également un dissipateur thermique 27, par exemple, identique à celui de la figure 2.

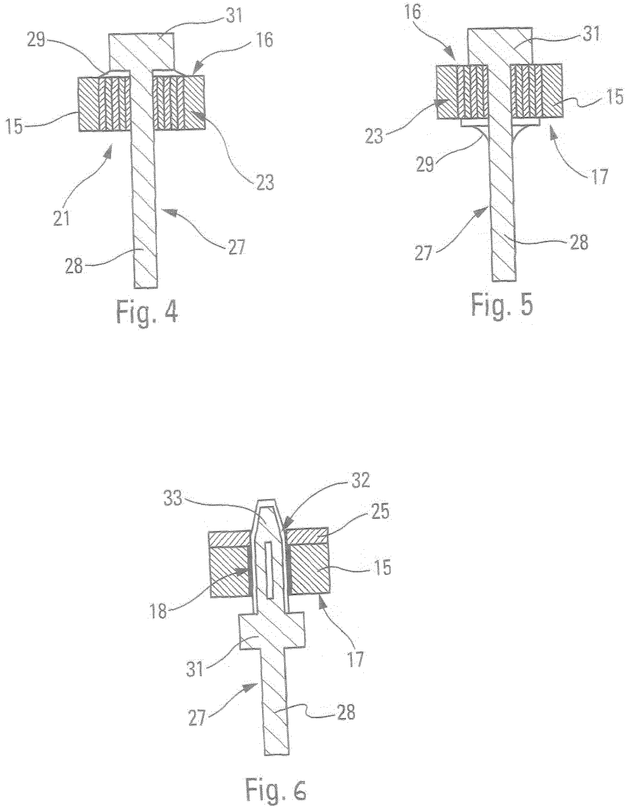

La troisième variante de l'invention est représentée à la figure 4. La partie 21 de la carte de circuit imprimé 15 reçoit un moyen conducteur de calories 23 identique à celui des figures 2 et 3. En revanche, le dissipateur thermique 27 présente une forme différente. En effet, celui-ci traverse de part en part la carte de circuit imprimé 15, au niveau du moyen conducteur de calories 23, par exemple au centre de celui-ci. Le barreau 28 présente alors une première extrémité libre qui débouche dans le flux d'air forcé et une seconde extrémité coiffée par une tête 31 formée préférentiellement de manière unitaire avec le barreau 28. La tête 31 forme un plat qui est solidarisé sur la première face 16 par une brasure 29 au droit du moyen conducteur de calories 23.

La variante de la figure 5 est proche de celle la figure 4. On détaillera ci-après la différence et on se reportera à la description de la figure 4 pour les éléments identiques. La différence réside dans le mode de solidarisation du dissipateur thermique 27 sur le moyen conducteur de calories 23.

Le dissipateur thermique 27 comprend un barreau 28 coiffé par une tête 31 identique à la variante de la figure 4. La tête 31 n'est pas brasée sur le moyen conducteur de calories 23 au niveau de la première face 16. Le dissipateur thermique 27 se trouve alors en appui par sa tête 31 sur une première extrémité du moyen conducteur de calories 23, et solidarisé à celui-ci par le biais d'une brasure 29 réalisée au niveau de la deuxième face 17.

La troisième variante (figure 4) et la quatrième variante (figure 5) de l'invention emploient un dissipateur thermique 27 qui présente une tête 31, cette dernière débordant, autrement dit dépassant, du plan de la première face 16 entre les composants électroniques solidarisés sur cette première face 16. En plus du moyen conducteur de calories, la tête contribue à capter les calories générées par les composants électroniques pour les drainer vers le barreau 28 léché par le flux d'air mis en mouvement par l'hélice.

La figure 6 montre une autre variante de réalisation. Le dissipateur thermique 27 comprend son barreau 28 surmonté de sa tête 31, destinée ici à former une butée contre la deuxième face 17 de la carte de circuit imprimé 15. Une telle tête 31 est interposée entre le barreau 28 et un plot de fixation 33 qui est enfilé à force dans le trou 18. La conduction thermique entre la piste électriquement conductrice 25 et le dissipateur thermique 27 est opérée par un contact physique entre le plot de fixation 33 et la piste conductrice 25, notamment à la périphérie externe du plot de fixation 33.

Le dispositif de ventilation 1 décrit dans les variantes ci-dessus peut comprendre une pluralité de trous 18 et/ou une pluralité de moyens conducteurs de calories 23 identiques et/ou une pluralité de dissipateurs thermiques 27 identiques.

Selon une autre variante, le dispositif de ventilation 1 selon la présente invention peut comprendre une combinaison de moyens conducteurs de calories 23 et/ou de dissipateurs thermiques 27 réalisés selon au moins deux variantes exposées ci-dessus.

Le dissipateur thermique 27 selon l'une quelconque des variantes présentées ci-dessus est avantageusement réalisé en un alliage d'aluminium.

## Revendications

1. Dispositif de ventilation (1) d'une installation de ventilation d'un habitacle de véhicule automobile comprenant une hélice (4) génératrice d'un flux d'air (11, 12) et apte à être entraînée par un moteur électrique, et une carte de circuit imprimé (15) sur laquelle est solidarisé au moins un composant électronique (19) susceptible de dégager des calories, ladite carte de circuit imprimé (15) comprenant au moins un trou (18) traversant ménagé dans une partie (21) de ladite carte de circuit imprimé (15), le dispositif de ventilation (1) étant configuré de sorte que ladite partie (21) de carte de circuit imprimé (15) est apte à être léchée par le flux d'air (11, 12) généré par l'hélice (4), la carte de circuit imprimé (15) étant délimitée par une première face (16) sur laquelle est solidarisé au moins le composant électronique (19) susceptible de dégager des calories et par une deuxième face (17) opposée à la première face (16) par rapport à ladite carte de circuit imprimé (15), **caractérisé en ce que** ladite deuxième face (17) forme au moins ladite partie (21) de carte de circuit imprimé (15) léchée par le flux d'air (11, 12), et qu'un moyen conducteur de calories (23) s'étend dans le trou (18).

2. Dispositif de ventilation selon la revendication 1, dans lequel la carte de circuit imprimé (15) forme un dispositif de commande apte à piloter le moteur électrique.

3. Dispositif de ventilation selon l'une des revendications 1 ou 2, dans lequel le moyen conducteur de calories (23) est formé par une partie métallisée (24) du trou (18).

4. Dispositif de ventilation selon la revendication 3, dans lequel le moyen conducteur de calories (23) est en contact avec une piste électriquement conductrice (25) qui s'étend sur la première face (16) au moins jusqu'au composant électronique (19).

5. Dispositif de ventilation selon l'une quelconque des revendications 1 à 4, dans lequel un périmètre externe du composant électronique (19) délimite une première emprise (30) sur la première face (16), le trou (18) délimite une deuxième emprise (26) sur la première face (16), la première emprise (30) et la deuxième emprise (26) étant séparées par une distance non-nulle.

6. Dispositif de ventilation selon l'une quelconque des revendications 1 à 4, dans lequel un périmètre externe du composant électronique (19) délimite une première emprise (30) sur la première face (16), le trou (18) délimite une deuxième emprise (26) sur la première face (16), la première emprise (30) et la deuxième emprise (26) se superposent au moins partiellement.

7. Dispositif de ventilation selon l'une quelconque des revendications 1 à 6, dans lequel un dissipateur thermique (27) est solidarisé sur la carte de circuit imprimé (15) au droit du ou dans le trou (18), ledit dissipateur thermique (27) débouchant de la deuxième face (17) de manière à être léché par le flux d'air (11, 12).

8. Dispositif de ventilation selon la revendication 7, dans lequel le dissipateur thermique (27) comprend une tête (31) formant butée d'appui contre la carte de circuit imprimé (15).

9. Dispositif de ventilation selon l'une quelconque des revendications précédentes, dans lequel la partie (21) de la carte de circuit imprimé (15) léchée par le flux d'air (11, 12) porte au moins une pluralité de pistes électriquement conductrices agencées pour limiter un risque de court-circuit.

10. Dispositif de ventilation selon l'une quelconque des revendications précédentes, dans lequel est prévue au moins une paroi (13, 14) séparant la carte de circuit imprimé (15) en ladite partie (21) léchée par le flux d'air (11, 12) et une zone (22) dépourvue dudit flux d'air.

11. Dispositif de ventilation selon la revendication 10, dans lequel la partie (21) de la carte de circuit imprimé (15) léchée par le flux d'air (11, 12) est dépourvue de composant électronique.

12. Dispositif de ventilation selon l'une quelconque des revendications 10 ou 11, **caractérisé en ce qu'**au moins un composant électronique (34) est solidarisé sur ladite zone (22).

13. Installation de ventilation comprenant un dispositif de ventilation (1) selon l'une quelconque des revendications précédentes.

## Patentansprüche

1. Belüftungsvorrichtung (1) für eine Belüftungsanlage eines Kraftfahrzeuginnenraums, umfassend ein Lüfterrad (4), das einen Luftstrom (11, 12) erzeugt und geeignet ist, von einem Elektromotor angetrieben zu werden, und eine Leiterplatte (15), auf der mindestens ein elektronisches Bauelement (19) befestigt ist, das Wärme abgeben kann, wobei die Leiterplatte (15) mindestens ein Durchgangsloch (18) umfasst, das in einem Teil (21) der Leiterplatte (15) ausgebildet ist, wobei die Belüftungsvorrichtung (1) so ausgestaltet ist, dass der Teil (21) der Leiterplatte (15) geeignet ist, von dem vom Lüfterrad (4) erzeugten Luftstrom (11, 12) überstrichen zu werden, wobei die Leiterplatte (15) durch eine erste Seite (16), auf der mindestens das elektronische Bauelement (19) befestigt ist, das Wärme abgeben kann, und durch eine zweite Seite (17), die in Bezug auf die Leiterplatte (15) zu der ersten Seite (16) entgegengesetzt ist, begrenzt wird, **dadurch gekennzeichnet, dass** die zweite Seite (17) mindestens den Teil (21) der Leiterplatte (15) bildet, der von dem Luftstrom (11, 12) überstrichen wird, und dass sich in dem Loch (18) ein Wärme leitendes Mittel (23) erstreckt.

2. Belüftungsvorrichtung nach Anspruch 1, bei der die Leiterplatte (15) eine Steuerungsvorrichtung bildet, die geeignet ist, den Elektromotor anzusteuern.

3. Belüftungsvorrichtung nach einem der Ansprüche 1 oder 2, bei der das Wärme leitende Mittel (23) durch einen metallisierten Teil (24) des Lochs (18) gebildet wird.

4. Belüftungsvorrichtung nach Anspruch 3, bei der das Wärme leitende Mittel (23) in Kontakt mit einer elektrisch leitenden Bahn (25) ist, die sich auf der ersten Seite (16) mindestens bis zu dem elektronischen Bauelement (19) erstreckt.

5. Belüftungsvorrichtung nach einem der Ansprüche 1 bis 4, bei der ein äußerer Umfang des elektronischen Bauelements (19) eine erste Fläche (30) auf der ersten Seite (16) begrenzt, das Loch (18) eine zweite Fläche (26) auf der ersten Seite (16) begrenzt, wobei die erste Fläche (30) und die zweite Fläche (26) durch einen Abstand ungleich null getrennt sind.

6. Belüftungsvorrichtung nach einem der Ansprüche 1 bis 4, bei der ein äußerer Umfang des elektronischen Bauelements (19) eine erste Fläche (30) auf der ersten Seite (16) begrenzt, das Loch (18) eine zweite Fläche (26) auf der ersten Seite (16) begrenzt, wobei die erste Fläche (30) und die zweite Fläche (26) sich zumindest teilweise überlagern.

7. Belüftungsvorrichtung nach einem der Ansprüche 1 bis 6, bei der ein Wärmeableiter (27) auf der Leiterplatte (15) lotrecht zu dem oder in dem Loch (18) befestigt ist, wobei der Wärmeableiter (27) auf der zweiten Seite (17) so mündet, dass er von dem Luftstrom (11, 12) überstrichen wird.

8. Belüftungsvorrichtung nach Anspruch 7, bei welcher der Wärmeableiter (27) einen Kopf (31) umfasst, der einen Stützanschlag gegen die Leiterplatte (15) bildet.

9. Belüftungsvorrichtung nach einem der vorhergehenden Ansprüche, bei welcher der Teil (21) der Leiterplatte (15), der von dem Luftstrom (11, 12) überstrichen wird, mindestens eine Mehrzahl von elektrisch leitenden Bahnen trägt, die angeordnet sind, um eine Kurzschlussgefahr zu begrenzen.

10. Belüftungsvorrichtung nach einem der vorhergehenden Ansprüche, bei der mindestens eine Wand (13, 14) vorgesehen ist, welche die Leiterplatte (15) in den von dem Luftstrom (11, 12) überstrichenen Teil (21) und in einen Bereich (22) ohne Luftstrom teilt.

11. Belüftungsvorrichtung nach Anspruch 10, bei welcher der Teil (21) der Leiterplatte (15), der von dem Luftstrom (11, 12) überstrichen wird, kein elektronisches Bauelement aufweist.

12. Belüftungsvorrichtung nach einem der Ansprüche 10 oder 11, **dadurch gekennzeichnet, dass** mindestens ein elektronisches Bauelement (34) auf dem Bereich (22) befestigt ist.

13. Belüftungsanlage mit einer Belüftungsvorrichtung (1) nach einem der vorhergehenden Ansprüche.

## Claims

1. Ventilation device (1) of a ventilation unit of a passenger compartment of a motor vehicle, comprising an impeller (4) generating an air flow (11, 12) and able to be driven by an electric motor, and a printed circuit board (15) on which at least one electronic component (19) able to release heat is attached, said printed circuit board (15) comprising at least one through-hole (18) provided in a part (21) of said printed circuit board (15), the ventilation device (1) being configured such that the air flow (11, 12) generated by the impeller (4) passes over said part (21) of the printed circuit board (15), the printed circuit board (15) being delimited by a first face (16) on which at least the electronic component (19) able to release heat is attached, and by a second face (17) opposite the first face (16) relative to said printed circuit board (15), **characterized in that** said second face (17) forms at least said part (21) of the printed circuit board (15) over which the air flow (11, 12) passes and **in that** a heat-conductive means (23) extends into the hole (18).

2. Ventilation device according to Claim 1, wherein the printed circuit board (15) forms a control device able to control the electric motor.

3. Ventilation device according to either of Claims 1 and 2, wherein the heat-conductive means (23) is formed by a metallized part (24) of the hole (18).

4. Ventilation device according to Claim 3, wherein the heat-conductive means (23) is in contact with an electrically conductive track (25) which extends over the first face (16) at least as far as the electronic component (19).

5. Ventilation device according to any of Claims 1 to 4, wherein an outer perimeter of the electronic component (19) delimits a first region (30) on the first face (16), the hole (18) delimits a second region (26) on the first face (16), the first region (30) and the second region (26) being separated by a distance not equal to zero.

6. Ventilation device according to any of Claims 1 to 4, wherein an outer perimeter of the electronic component (19) delimits a first region (30) on the first face (16), the hole (18) delimits a second region (26) on the first face (16), the first region (30) and the second region (26) overlapping at least partly.

7. Ventilation device according to any of Claims 1 to 6, wherein a heat sink (27) is attached to the printed circuit board (15) at the level of or in the hole (18), said heat sink (27) opening from the second face (17) so that the air flow (11, 12) passes over it.

8. Ventilation device according to Claim 7, wherein the heat sink (27) comprises a head (31) forming a support stop against the printed circuit board (15) .

9. Ventilation device according to any of the preceding claims, wherein the part (21) of the printed circuit board (15) over which the air flow (11, 12) passes carries at least a plurality of electrically conductive tracks configured to limit a risk of short-circuit.

10. Ventilation device according to any of the preceding claims, wherein at least one wall (13, 14) is provided separating the printed circuit board (15) into said part (21) over which the air flow (11, 12) passes and a zone (22) without such an air flow.

11. Ventilation device according to Claim 10, wherein the part (21) of the printed circuit board (15) over which the air flow (11, 12) passes carries no electronic components.

12. Ventilation device according to one of Claims 10 or 11, **characterized in that** at least one electronic component (34) is attached to said zone (22) .

13. Ventilation unit comprising a ventilation device (1) according to any of the preceding claims.
